# EUROPEAN PATENT APPLICATION

(11) **EP 2 339 907 A2**
(43) Date of publication of application: **29.06.2011**
(21) Application number: 10195992.2
(22) Date of filing: 20.12.2010
(51) Int. Cl.: H05K 7/20

(54) **Ventilation system and rack apparatus**

(30) Priority: 28.12.2009 JP 2009296980
(71) Applicant: FUJITSU LIMITED, Kawasaki-shi, Kanagawa 211-8588 (JP)
(72) Inventor: Yamaguchi, Atsushi, Kawasaki-shi, Kanagawa 211-8588 (JP); Ishimine, Junichi, Kawasaki-shi, Kanagawa 211-8588 (JP); Nitta, Kazuhiro, Kawasaki-shi, Kanagawa 211-8588 (JP); Ueda, Akira, Kawasaki-shi, Kanagawa 211-8588 (JP)
(74) Representative: Stebbing, Timothy Charles

(57) **Abstract**

A ventilation system (300) includes a plurality of fan units. Each of the fan units includes a fan (310) to generate an air stream, and a duct (320) disposed upstream of the air stream with respect to the fan and defining a flow channel having a square-shaped section to guide air into the fan, the flow channel being coaxial with a rotating shaft (311) of the fan. The fan units are arranged in a direction crossing the shaft so that the rotating shafts are disposed in parallel to each other.

## Description

The present invention relates to a fan-based a ventilation system and a rack apparatus which has the ventilation system for cooling equipment mounted thereon.

Electronic equipment, such as a server device, often has a cooling fan inside to disperse heat generated during operation of the equipment. The fan takes ambient air into the equipment for a cooling purpose (for example, see Japanese Laid-open Utility Model Publication No. 6-87695, Japanese Laid-open Patent Publication No. 2007-218150 and Japanese Laid-open Patent Publication No. 3-168399).

Most of the electronic equipment recently has achieved higher performance and, as a result, increased in the amount of heat generation during operation. Such electronic equipment has become more compact and thinner and it is difficult to let air flow therethrough. Thus, an amount of air may often be insufficient to the ever-increasing amount of heat generation. To address this problem, for example, the electronic equipment is often provided with a plurality of fans disposed side by side and a rotational speed of vanes of each of the fans is set to be relatively high to provide a sufficient amount of air. In many cases, the electronic equipment, such as a server device, is used in a state in which multiple pieces of them (multiple units) are mounted in an equipment mounting rack.

Such an equipment mounting rack is often annoyingly noisy because each of the multiple pieces of electronic equipment mounted thereon produces noise during operation. In order to reduce the noise, recent equipment mounting racks include walls of noise absorbing material disposed to surround an electronic equipment mounting space as a noise control measure.

In such equipment mounting racks with a noise control measure, however, the walls of noise absorbing material surrounding the equipment mounting space increase resistance against inflow air in a path of the inflow air to equipment mounting space. Thus, a volume of intake air may often be insufficient for the purpose of cooling the electronic equipment. To address this problem, such equipment mounting rack is often provided with a fan which takes ambient air into the electronic equipment mounting space. Further, such equipment mounting racks are often provided with a plurality of fans disposed side by side and a rotational speed of vanes of each of the fans is set to be relatively high to provide a sufficient amount of air into the electronic equipment mounting space.

Generally, when the rotational speed of vanes of a fan is increased, the noise produced by the fan during operation becomes significantly louder in proportion to the fifth or sixth power of an increase in the rotational speed. Thus, the recent electronic equipment often with a plurality of fans of which rotational speed is set relatively high for the sufficient amount of air tends to produce increasingly loud noise from the fans.

When the electronic equipment is mounted in an equipment mounting rack with a noise control measure mentioned above, the noise produced by the fans of the electronic equipment themselves may be reduced. However, loud noise will be produced by the plurality of fans of which rotational speed is set relatively high to provide a sufficient amount of air into the electronic equipment mounting space. In recent years, such equipment mounting racks are often installed in offices where people often complain about the noise produced by the fans of the equipment mounting racks.

Accordingly, it is desirable to provide a ventilation system that provides a sufficient amount of air with reduced noise.

According to an aspect of the embodiment, a ventilation system includes a plurality of fan units. Each of the fan units includes a fan to generate an air stream, and a duct disposed upstream of the air stream with respect to the fan and defining a flow channel having a square-shaped section to guide air into the fan, the flow channel being coaxial with a rotating shaft of the fan. The fan units are arranged in a direction crossing the shaft so that the rotating shafts are disposed in parallel to each other. Reference is made, by way of example only, to the accompanying drawings in which:

FIG. 1A to FIG. 1C illustrate an equipment mounting rack according to a first embodiment.

FIG. 2 schematically illustrates an internal structure of a server device according to the first embodiment.

FIG. 3A to FIG. 3C illustrate an equipment mounting rack according to a comparative example.

FIG. 4 is a perspective view of a ventilation system according to the first embodiment.

FIG. 5A to FIG. 5C illustrate details of a set of a fan and a duct in a ventilation system according to the first embodiment.

FIG. 6 illustrates loss of rotational balance of vanes when a duct constituted by a plurality of walls which are not equally distant from a shaft is attached to a fan.

FIG. 7 illustrates noise reduction in a ventilation system by a structure in which each of the fans is provided with a duct according to the first embodiment.

FIG. 8 illustrates loss of rotational balance of vanes of each fan when a plurality of fans share a single duct.

FIG. 9 illustrates a state in which a round-section duct is attached to a fan.

FIG. 10 is a graph representing a P-Q characteristic, an impedance characteristic and a noise characteristic, in which the P-Q characteristic is a change in static pressure (P) with respect to an amount of air (Q) in a square-section duct fan, the impedance characteristic is a change in ventilation resistance with respect to the amount of air, and the noise characteristic is a change in a noise level with respect to the amount of air.

FIG. 11 is a graph representing the P-Q characteristic, the impedance characteristic and the noise characteristic when a necessary amount of air illustrated in FIG. 10 is supplied by a round-section duct fan.

FIG. 12 is a graph representing relationships between noises produced by a square-section duct fan or a round-section duct fan and a rotational frequency of vanes of the fans.

FIG. 13 is a table of calculation results of an increase in noise when a round-section duct is attached as compared with a case when a square-section duct is attached.

FIG. 14 is a table of calculation results of an increase in noise when a round-section duct is attached as compared with a case when a square-section duct is attached.

FIG. 15 is a table of an amount of noise attenuation depending on a duct length.

FIG. 16 is a table of an amount of noise attenuation available in a duct of a length in a preferred range.

FIG. 17 is a sectional view illustrating a structure in which a duct is attached to each fan according to a second embodiment.

Hereinafter, embodiments of a ventilation system and an equipment mounting rack will be described with reference to the drawings.

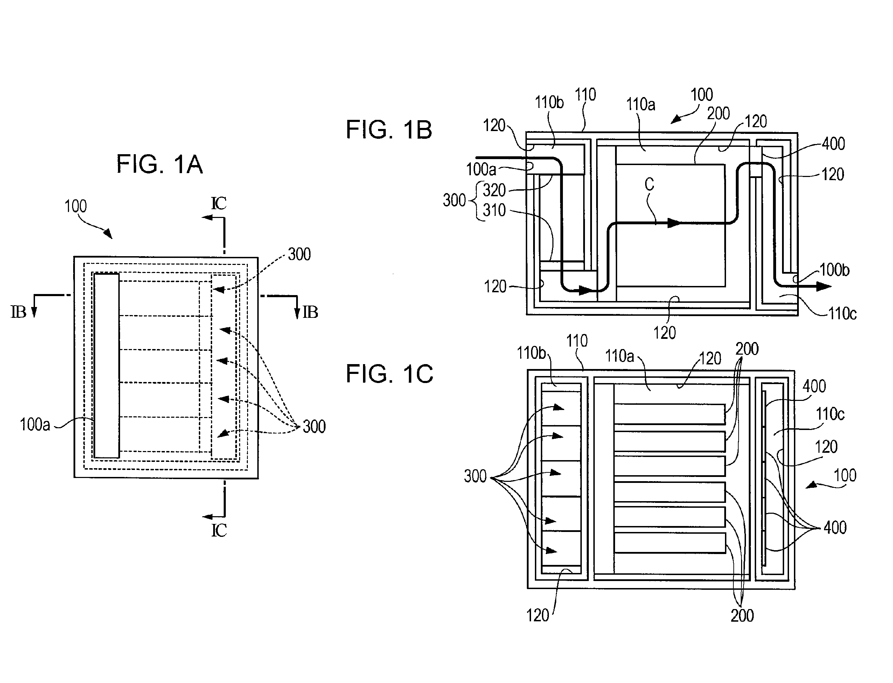

FIG. 1A to FIG. 1C illustrate an equipment mounting rack according to a first embodiment.

FIG. 1A illustrates a side surface of an equipment mounting rack 100. FIG. 1B is a sectional view taken along line IB-IB in FIG. 1A. FIG. 1C is a sectional view taken along line IC-IC in FIG. 1A.

The equipment mounting rack 100 illustrated in FIG. 1A to FIG. 1C is provided with a rack housing 110. The rack housing 110 includes an equipment mounting space 110a, a first air guide duct 110b and a second air guide duct 110c which will be described below.

Six server devices 200 are mounted in the equipment mounting space 110a in a stacked manner. The first air guide duct 110b is a passage through which ambient air is taken into the equipment mounting space 110a for the purpose of cooling the server devices 200. The second air guide duct 110c is a passage through which air is guided to be exhausted out of the equipment mounting rack 100 from the equipment mounting space 110a after cooling the server devices 200.

Each of the server devices 200 mounted in the equipment mounting space 110a has a function to cool electronic components or other devices inside by taking in ambient air.

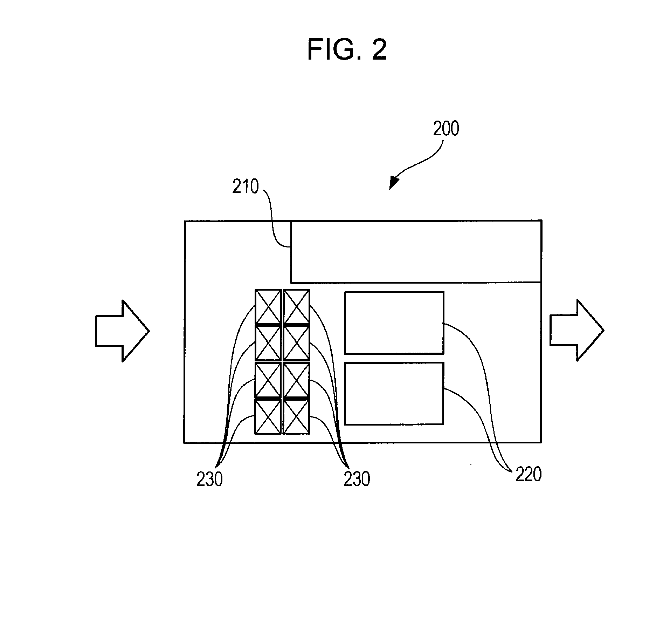

FIG. 2 schematically illustrates an internal structure of a server device according to the first embodiment.

As illustrated in FIG. 2, each of the server devices 200 has a plurality of electronic components 220 inside. The electronic components 220 operate with electric power supplied from a power supply unit 210 and generate heat during operation. Each of the server devices 200 is provided with fans 230 for taking ambient air for the purpose of cooling the electronic components 220.

In the first embodiment, since the server devices 200 are thin, it is difficult to cause the cooling air to flow through the server devices 200. If an amount of intake ambient air is small, the amount of air inside the server devices 200 may be insufficient. In order to avoid such insufficiency of air, each of the server devices 200 has a plurality of device fans 230 disposed side by side to take in as much air as possible. A rotational speed of vanes of each of the device fans 230 is set to be relatively high to increase the amount of ambient air taken in.

Generally, when the rotational speed of vanes of a fan is increased, the noise produced by the fan during operation becomes significantly louder in proportion to the fifth or sixth power of an increase in the rotational speed. Thus, in the server devices 200 of the first embodiment, the device fans 230 with vanes of which rotational speed is set relatively high produce loud noise. Since each of the server devices 200 of the present embodiment are provided with a plurality of device fans 230, the entire equipment produces even louder noise.

As described above, in the first embodiment, it is considered to be more important to take as much air as possible into the server devices 200 than to reduce noise.

In order to reduce noise, in the equipment mounting rack 100 illustrated in FIG. 1A to FIG. 1C, the following noise control measure is taken to prevent a leakage of noise produced by the server devices 200 mounted on the rack 100.

In the first embodiment, as illustrated in FIG. 1B, the equipment mounting space 110a in which the server devices 200 are mounted is disposed between the first guide duct 110b, upstream of the airflow and the second air guide duct 110c, and downstream of the airflow along a direction of arrow C in FIG. 1B. As illustrated in FIG. 1A or FIG. 1B, an air inlet 100a for taking ambient air into the equipment mounting rack 100 for the purpose of cooling the server devices 200 is provided on a side wall of the equipment mounting rack 100, which side wall constitutes the first air guide duct 110b. An air outlet 100b through which air is exhausted after cooling is provided on a side wall which constitutes the second air guide duct 110c. With this structure, the equipment mounting space 110a is separated from the outside of the equipment mounting rack 100 and therefore a leakage of noise produced by the server devices 200 is reduced.

The equipment mounting space 110a, the first air guide duct 110b and the second air guide duct 110c each have a plate-shaped noise-absorbing member 120 on their inner wall surfaces. The noise-absorbing member 120 is formed of noise-absorbing rubber or other material having noise absorbing properties greater than that of walls of the rack housing 110. In this manner, the equipment mounting space 110a of the first embodiment is surrounded by the noise-absorbing members 120. Noise produced by the server devices 200 is absorbed by the noise-absorbing members 120.

In the first embodiment, the noise-absorbing members 120 attached to the first and second air guide ducts 110b and 110c also function to absorb noise produced by a later-described plurality of fans provided in the equipment mounting rack 100.

In the equipment mounting rack 100, the air taken into the equipment mounting rack 100 through the air inlet 100a for the cooling purpose flows toward the equipment mounting space 110a via the first air guide duct 110b. Thus, the air drawn into the equipment mounting space 110a tends to flow less smoothly as compared with a case in which, for example, the air inlet is provided directly in a wall that surrounds the equipment mounting space 110a. To avoid this problem, the equipment mounting rack 100 is provided with a ventilation system 300. The ventilation system 300 is disposed in the middle of the first air guide duct 110b to actively supply air flowing in the first air guide duct 110b into the equipment mounting space 110a.

The ventilation system 300 includes five fans 310 arranged in a direction perpendicular to the flow of air, and five ducts 320 each of which is connected to an air inlet of each of the fans 310. The ventilation system 300 has five fans 310 to promote the flow of air which tends to be less smooth as described above and to provide a sufficient amount of air flowing into the equipment mounting space 110a. A rotational speed of vanes of each of the fans 310 is set to be relatively high to increase ventilation capacity.

The equipment mounting rack 100 also has five fans 400 at an outlet of the equipment mounting space 110a. The fans 400 guide air exhausted out of (expelled from) the server devices 200 after cooling toward the second air guide duct 110c from the equipment mounting space 110a. It is not necessary that the fans 400 at the second air guide duct 110c side have ventilation capacity as high as that of the fans 310 at the first air guide duct 110b side. It suffices that the fans 400 can send air toward the second air guide duct 110c. For this reason, noise reduction is considered more important than ventilation capacity for the fans 400 at the second air guide duct 110c side and thus the rotational speed of vanes of the fans 400 is set to be relatively low.

Hereinafter, an equipment mounting rack according to a comparative example will be described in comparison with the equipment mounting rack 100 of the first embodiment.

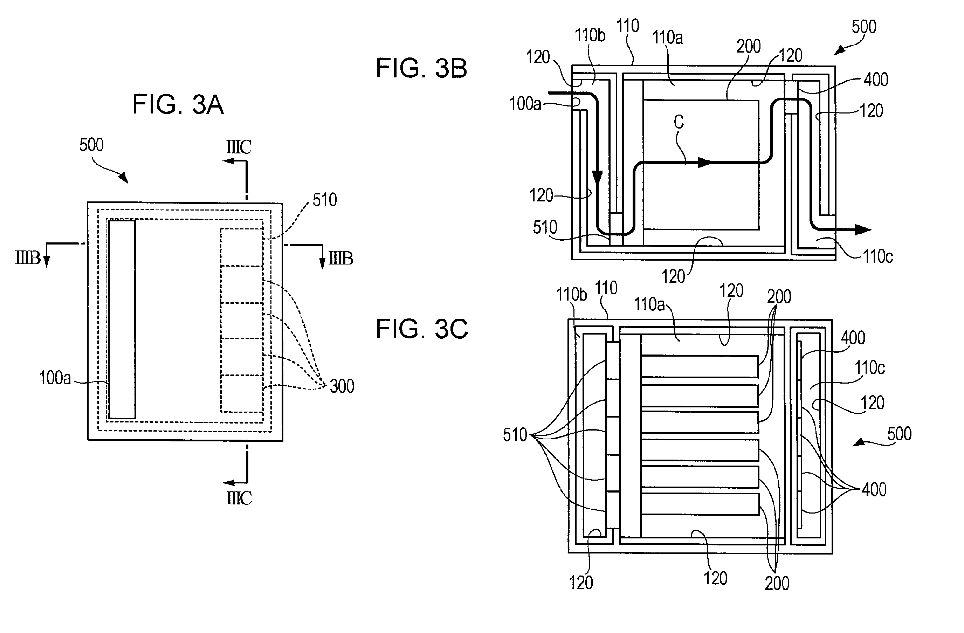

FIG. 3A to FIG. 3C illustrate the equipment mounting rack according to the comparative example.

FIG. 3A illustrates a side surface of the equipment mounting rack 500 according to the comparative example. FIG. 3B is a sectional view taken along line IIIB-IIIB in FIG. 3A. FIG. 3C is a sectional view taken along line IIIC-IIIC in FIG. 3A.

In FIG. 3A to FIG. 3C, components equivalent to those of the equipment mounting rack 100 of the first embodiment illustrated in FIG. 1A to FIG. 1C are denoted by the same reference numerals as FIG. 1A to FIG. 1C and description thereof will be omitted.

In the equipment mounting rack 500 according to the comparative example illustrated in FIG. 3A to FIG. 3C, five fans 510 for supplying sufficient air into an equipment mounting space 110a are provided at an inlet of the equipment mounting space 110a.

Similar to the five fans 310 of the ventilation system 300 of the first embodiment described above, vanes of the five fans 510 have relatively high rotational speed for increased ventilation capacity. Generally, when the rotational speed of vanes of a fan is increased, the noise produced by the fan during operation becomes significantly louder in proportion to the fifth or sixth power of an increase in the rotational speed. For this reason, the fans with vanes of which rotational speed is set relatively high as described above produce loud noise.

In the equipment mounting rack 500 according to the comparative example, the total amount of noise produced by the five fans 510 is controlled only by walls of a first air guide duct 110b and a noise-absorbing member 120. However, noise produced by the fans 510 as described above is often too loud to be controlled only by the walls of the first air guide duct 110b and the noise-absorbing member 120. In recent years, such equipment mounting racks are often installed in offices. If, for example, the comparative equipment mounting rack 500 illustrated in FIG. 3A to FIG. 3C is installed in an office, people may often complain about the loud noise produced by the comparative equipment mounting rack 500.

As compared with the equipment mounting rack 500 according to the comparative example described above, noise produced by the fans 310 of the ventilation system 300 with vanes of which rotational speed is set to be relatively high is controlled by the ducts 320 connected to the fans 310 in the equipment mounting rack 100 of the first embodiment illustrated in FIG. 1A to FIG. 1C.

Hereinafter, details of the ventilation system 300 will be described focusing on a mechanism of the ventilation system 300 that reduces noise produced by the fans 310.

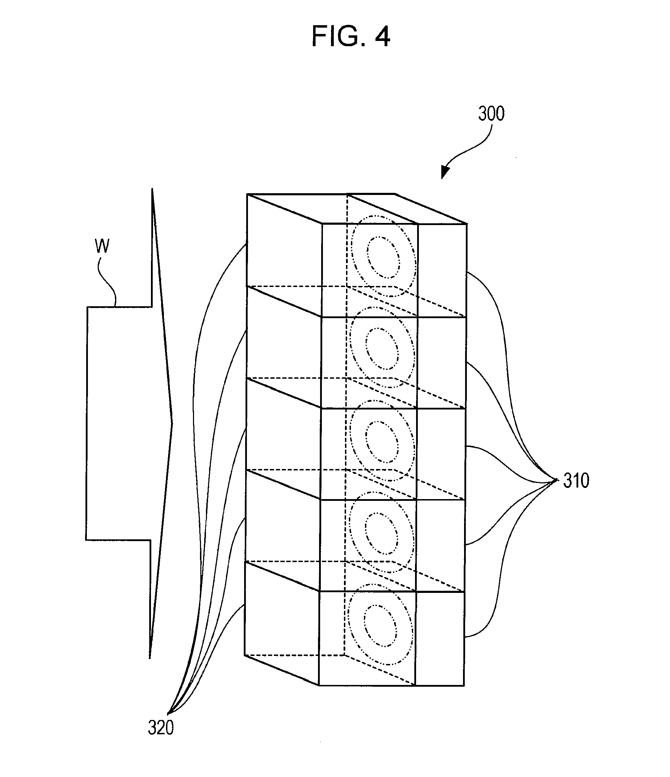

FIG. 4 is a perspective view of the ventilation system 300.

As illustrated in FIG. 4, the ventilation system 300 has five fans 310 arranged in a direction perpendicular to the flow of air W. Each of the ducts 320 connected to the air inlet each of the fans 310 has a square section.

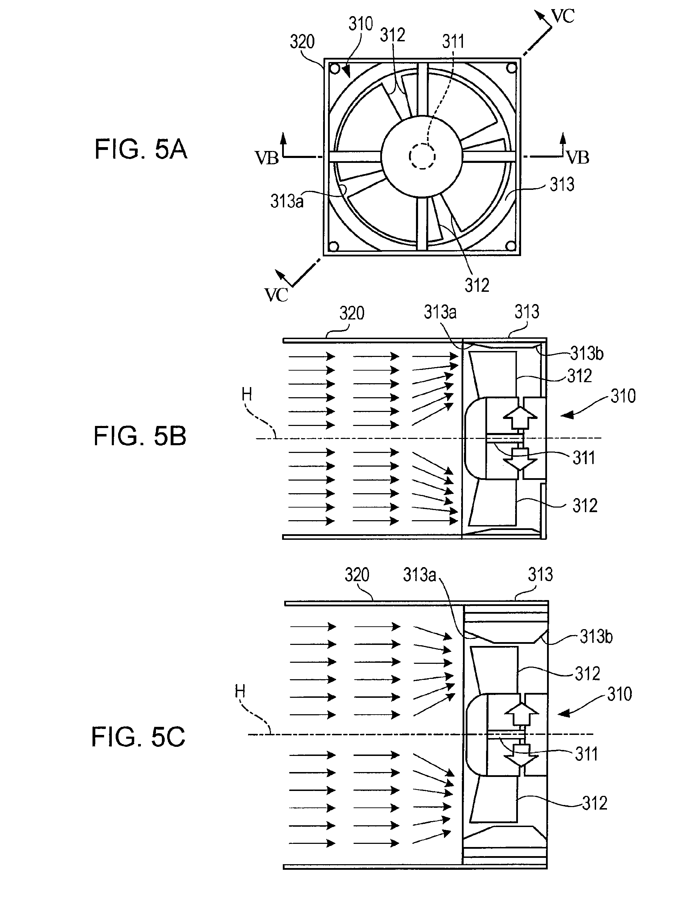

FIG. 5A to FIG. 5C illustrate details of a set of a fan and a duct of the ventilation system.

FIG. 5A is a plan view of a set of a fan 310 and a duct 320 seen from a side in which air flows in. FIG. 5B is a sectional view of the set of the fan 310 and the duct 320 taken along line VB-VB in FIG. 5A. FIG. 5C is a sectional view of the set of the fan 310 and the duct 320 taken along line VC-VC in FIG. 5A.

The fan 310 includes a shaft 311, vanes 312 and a cylindrical-shaped housing 313. The vanes 312 are attached to the shaft 311. The housing 313 extends along the shaft 311. As illustrated in FIG. 5A, in the first embodiment, the housing 313 of the fan 310 is formed as a square seen from a side in which air is caused to flow in. An internal cylinder of the fan 310 is a cylindrical-shaped pipe surrounding the vanes 312.

As the shaft 311 of the fan 310 is rotated, the vanes 312 generate a flow of air from an air inflow end 313a toward an air outflow end 313b. As illustrated in FIG. 4, in the ventilation system 300 of the first embodiment, five fans 310 are arranged in a direction perpendicular to the flow of air.

The duct 320 is a square-section duct which is larger than the air inflow end 313a in cross section. The duct 320 is connected to the air inflow end 313a and guides air flowing into the fan 310 toward the air inflow end 313a. An extension line H of a central axis of the square-section duct 320 is coincident with the shaft 311. An outside dimension of the duct 320 is coincident with an outside dimension of the square-shaped housing 313 of the fan 310.

Those fans which generate a flow of air with vanes as a shaft is rotated, such as the fan 310 of the first embodiment, the generated inflow of air hits the rotating vanes. When the air non-uniformly hits the vanes, force is exerted unevenly on the vanes. Thus, a rotational balance of the vanes is lost and, as a result, noise is produced.

In the first embodiment, the duct 320 which guides the air to the air inflow end 313a of the fan 310 has a square section and the extension line H of the central axis of the square-section duct 320 is coincident with the shaft 311. In this structure, four walls which constitute the duct 320 are substantially equally distanced from the shaft 311. Thus, as illustrated in the sectional view of FIG. 5B taken along line VB-VB which is parallel to walls of the duct 320, air is guided to the fan 310 so as to hit each of the vanes 312 uniformly in the section parallel to the walls. In this structure, four corners of the duct 320 are also substantially equally distanced from the shaft 311. Thus, as illustrated in the sectional view of FIG. 5C taken along line VC-VC which is a diagonal line of the square section of the duct 320, air is guided to the fan 310 so as to hit each of the vanes 312 uniformly also in the section along the diagonal line of the square.

In the first embodiment, since the duct 320 has a square section, air is guided to the fan 310 so as to hit the vanes 312 uniformly in every section that includes the central axis H of the duct 320. Thus, the rotational balance of the vanes 312 is kept during operation of the fan 310.

In a structure in which a duct constituted by a plurality of walls which are not equally distant from a shaft is attached to a fan, as compared with the structure of the first embodiment, the rotational balance of the vanes is lost. The loss of balance will be described below.

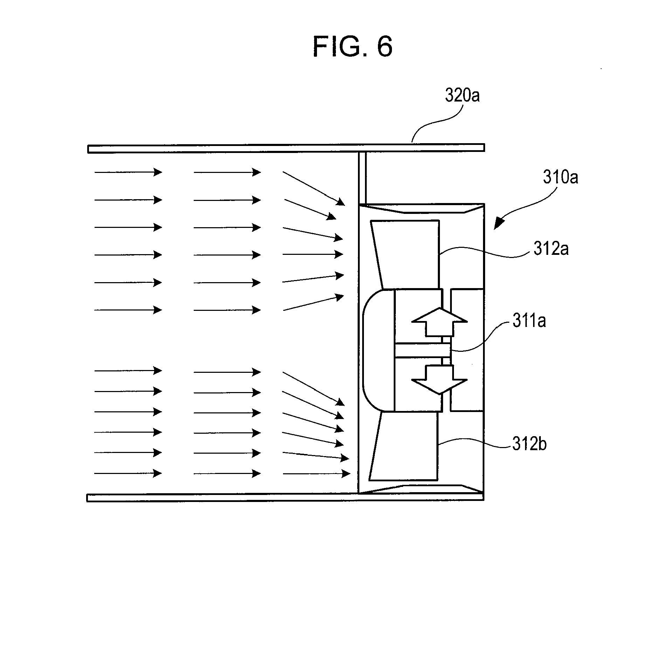

FIG. 6 illustrates loss of rotational balance of vanes when a duct constituted by a plurality of walls which are not equally distant from a shaft is attached to a fan.

FIG. 6 illustrates a sectional view of a state in which, unlike the first embodiment, a duct 320a constituted by a plurality of walls which are not equally distant from a shaft 311a is attached to a fan 310a at an inflow side of air. The fan 310a is equivalent to the fan 310 of the present embodiment. As illustrated in FIG. 6, an upper wall of the duct 320a in the drawing is more distant from the shaft 311a than a lower wall. With this structure, a vane 312a near the upper wall in the drawing receives a larger amount of air passing through the duct 320a than a vane 312b near the lower wall in the drawing. Since greater force is exerted on the vane 312a than on the vane 312b, the rotational balance of vanes is lost.

In the first embodiment, since air is guided to the fan 310 by the square-section duct 320 so as to hit the vanes 312 uniformly, the rotational balance of the vanes 312 is kept during operation of the fan 310. In this manner, noise produced by the fan 310 is reduced.

In the ventilation system 300 of the first embodiment, the five fans 310 are arranged in the direction perpendicular to the flow of air as described above. As illustrated in FIG. 4, a duct 320 is attached to each of the five fans 310. As described above, noise can be reduced in the ventilation system 300 of the first embodiment also by a structure in which each of the fans 310 is provided with a duct 320.

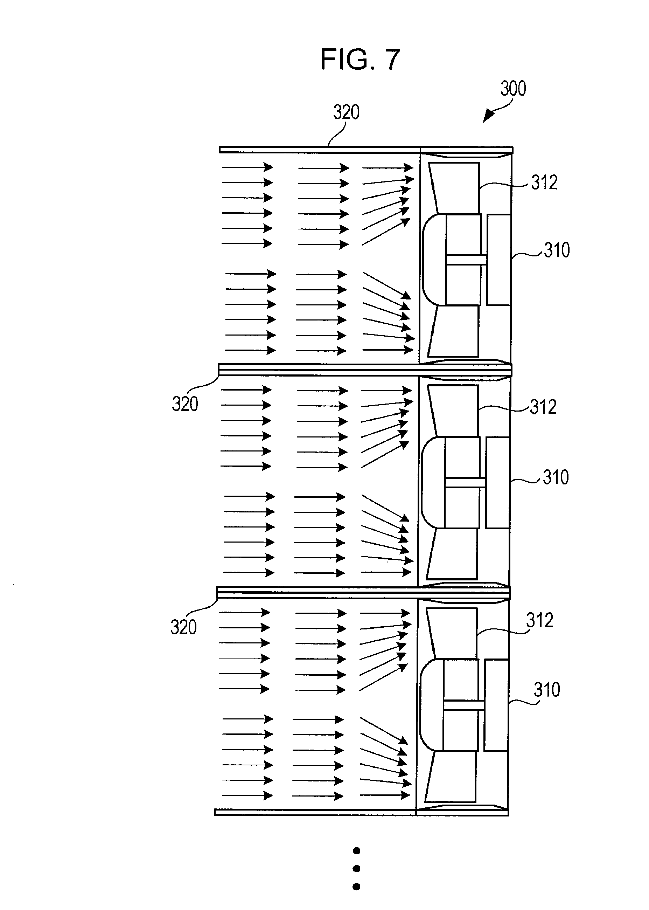

FIG. 7 illustrates noise reduction in a ventilation system by a structure in which each of the fans is provided with a duct.

FIG. 7 is a longitudinal sectional view of the ducts 320 in the ventilation system 300 in which the fans 310 and the ducts 320 are arranged in a manner as illustrated in FIG. 4.

As illustrated in FIG. 7, in the first embodiment, each of the fans 310 is provided with a square-section duct 320. The square-section duct 320 makes the air uniformly hit the vanes 312 of each of the fans 310. Thus, the rotational balance of the vanes 312 of each of the fans 310 is kept as described above.

In a structure, for example, in which a plurality of fans share a single duct, as compared with the structure of the first embodiment, the rotational balance of vanes is lost. The loss of balance will be described below.

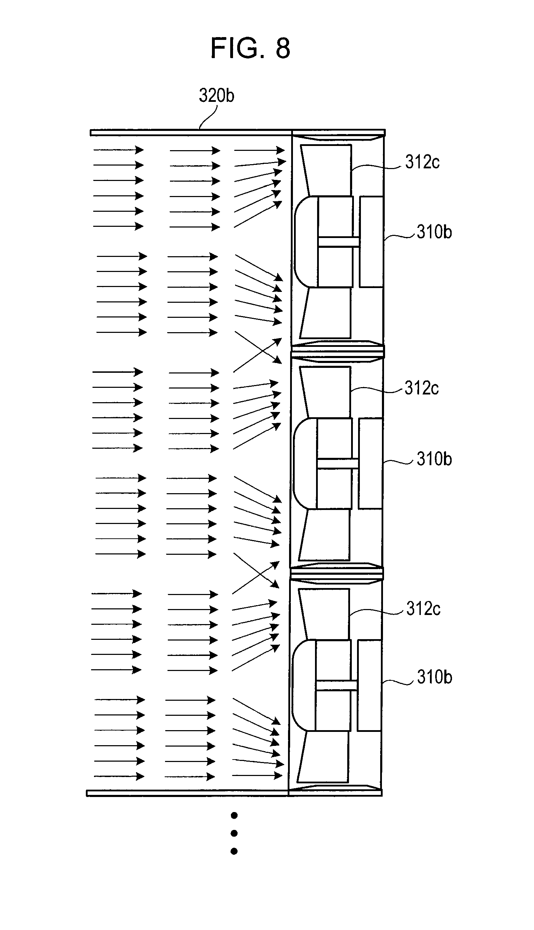

FIG. 8 illustrates loss of rotational balance of vanes of each fan when a plurality of fans share a single duct.

FIG. 8 is a sectional view of a structure in which a single elongated rectangular-section duct 320b is attached to three fans 310b which are equivalent to the fans 310 of the first embodiment. In this structure, flows of air supplied to each of the fans 310b cross each other between adjacent fans 310b and thereby are disturbed. As a result, the force is non-uniformly exerted on the vanes 312c of each of the fans 310b and the rotational balance of the vanes 312c of each of the fans 310b is lost.

In the first embodiment, however, the duct 320 attached to each of the fans 310 guides air separately to each of the fans 310 so that air hits the vanes 312 uniformly. Thus, a disturbance of the flow of air as described above can be avoided. In this manner, the rotational balance of the operating vanes 312 is kept for all the fans 310. As a result, noise produced by the entire ventilation system 300 is reduced.

In the first embodiment, as described above, noise produced by the fans 310 is reduced by a structure in which the square-section duct 320 attached to each of the fans 310 guides the air to the corresponding fan 310 so that the air uniformly hits the vanes 312.

It may be considered that a round-section duct is more preferable than the square-section duct 320 of the present invention for the purpose of guiding air to the fan 310. However, the square-section duct 320 is adopted in the present embodiment by the following reason.

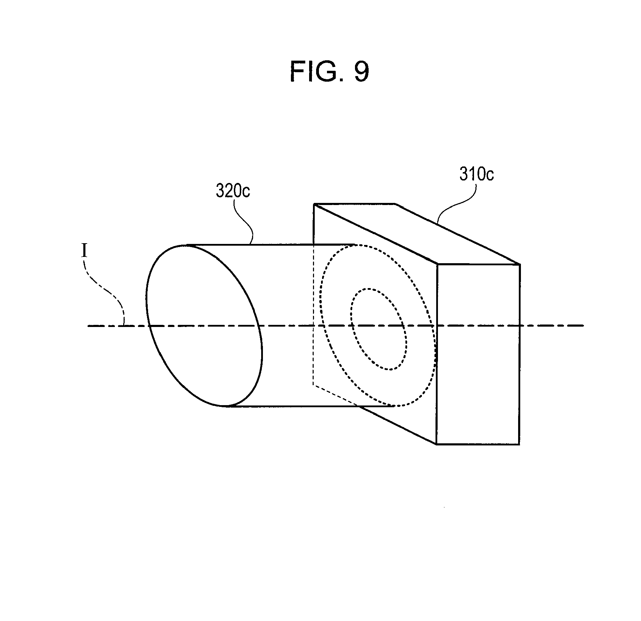

FIG. 9 illustrates a state in which a round-section duct is attached to a fan.

FIG. 9 is a perspective view of a state in which a round-section duct 320c is attached to a fan 310c at an inflow side of air unlike the first embodiment. The fan 310c is equivalent to the fan 310 of the first embodiment. An extension line I of a central axis of the round-section duct 320c is coincident with a shaft of the fan 310c. With this structure, inner wall surfaces of the duct 320c are equally distant from the shaft 311 as compared with those of the square-section duct 320 of the first embodiment in a strict sense. Thus, in the structure illustrated in FIG. 9, air is guided to hit the vanes of the fan 310c in a more uniform manner.

However, a round cross section of the round-section duct 320c perpendicular to the flow of air along the longitudinal direction is smaller than a square cross section of the square-section duct 320 of the first embodiment perpendicular to the flow of air along the longitudinal direction. Thus, ventilation resistance of the flow of air in the round-section duct 320c is larger than that in the square-section duct 320. As the ventilation resistance becomes high, the amount of air will be reduced. Accordingly, in order to compensate for the decrease in the amount of air and to provide an amount of air equivalent to that of the first embodiment with the structure illustrated in FIG. 9, it is necessary to increase the rotational speed of the vanes and increase ventilation capacity of the fan 310c. However, as the rotational speed increases, the fan may produce louder noise.

Hereinafter, the production of louder noise caused when an amount of air equivalent to that obtained with a square-section duct fan is provided with a round-section duct fan will be described.

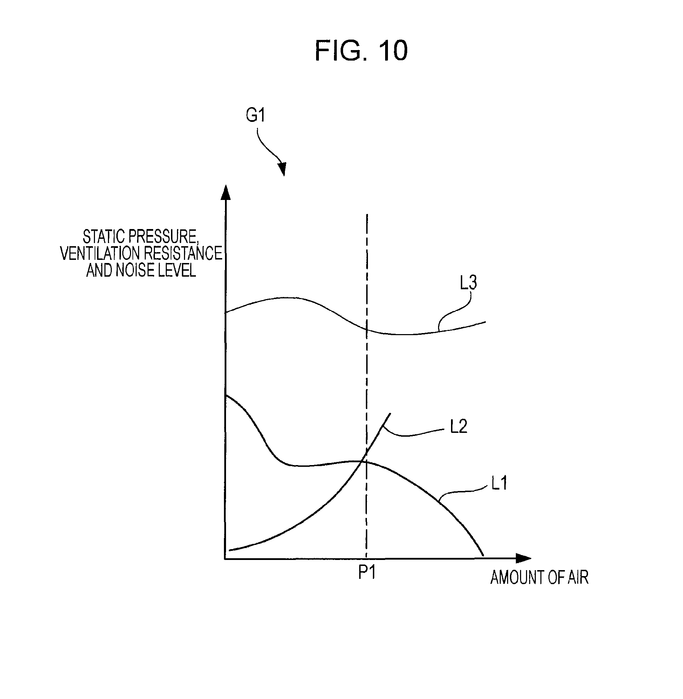

FIG. 10 is a graph representing a P-Q characteristic, an impedance characteristic and a noise characteristic, in which the P-Q characteristic is a change in static pressure (P) with respect to an amount of air (Q) in a square-section duct fan, the impedance characteristic is a change in ventilation resistance with respect to the amount of air, and the noise characteristic is a change in a noise level with respect to the amount of air.

In the graph G1 of FIG. 10, the amount of air is plotted in the horizontal axis while the static pressure, the ventilation resistance and the noise level are plotted in the vertical axis.

The graph G1 illustrates a first P-Q characteristic curve L1 representing the P-Q characteristic in the square-section duct fan, a first impedance characteristic curve L2 representing the impedance characteristic, and the first noise characteristic curve L3 representing the noise characteristic.

Here, an amount of air at the level illustrated by a dashed dotted line in the graph G1 of FIG. 10 is considered to be an amount of air P1 necessary for the cooling purpose. Now, a change in the P-Q characteristic, the impedance characteristic and the noise characteristic when the necessary amount of air P1 is supplied by a round-section duct fan will be discussed.

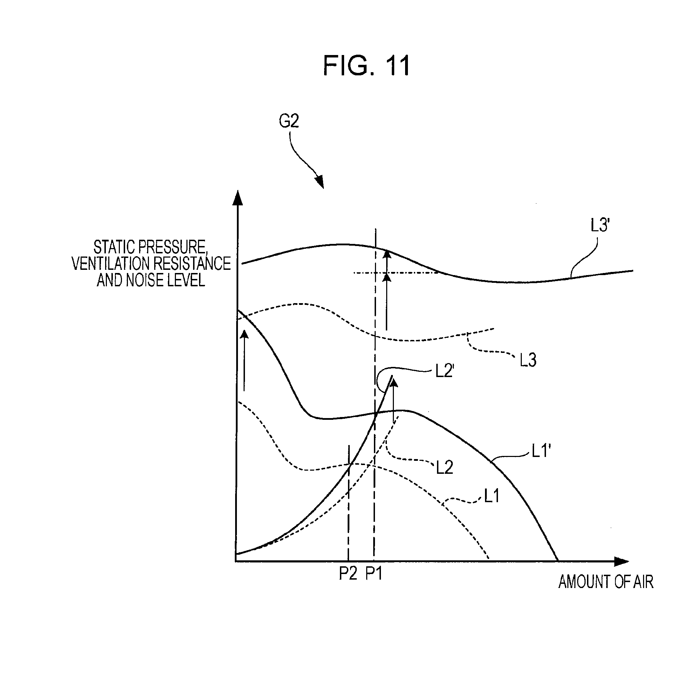

FIG. 11 is a graph representing the P-Q characteristic, the impedance characteristic and the noise characteristic when a necessary amount of air illustrated in FIG. 10 is supplied by a round-section duct fan.

In the graph G2 of FIG. 11, the amount of air is plotted in the horizontal axis while the static pressure, the ventilation resistance and the noise level are plotted in the vertical axis. In the graph G2, the first P-Q characteristic curve L1, the first impedance characteristic curve L2 and the first noise characteristic curve L3 on the graph G1 of FIG. 10 are represented by dotted lines.

Since the round cross section of the round-section duct fan is smaller than the square cross section of the square-section duct as described above, ventilation resistance of the round-section duct fan is larger than that of the square-section duct fan when an arbitrary amount of air is ventilated. Thus, the impedance characteristic of the round-section duct fan is larger than that of the square-section duct fan. In the graph G2 of FIG. 11, a second impedance characteristic curve L2' representing the impedance characteristic of the round-section duct fan is illustrated.

Here, it is assumed that ventilation capacity of a round-section duct fan is equivalent to that of a square-section duct fan, i.e., the P-Q characteristic of a round-section duct fan is equivalent to that represented by the first P-Q characteristic curve L1 above.

Then, an amount of air which can be supplied by the round-section duct fan is an amount of air P2 that corresponds to an intersection of the second impedance characteristic curve L2', which represents a high impedance characteristic as described above, and the first P-Q characteristic curve L1. As FIG. 11 illustrates, the amount of air P2 is smaller than the necessary amount of air P1.

In order to compensate for the insufficiency with respect to the necessary amount of air P1 and to provide the necessary amount of air P1 by the round-section duct fan, it is necessary to increase the P-Q characteristic represented by the first P-Q characteristic curve L1 to a P-Q characteristic described below. That is, in order to provide the necessary amount of air P1, it is necessary to increase the P-Q characteristic to a P-Q characteristic represented by the second P-Q characteristic curve L1' on the graph G2 which crosses a point which corresponds to the necessary amount of air P1 on the second impedance characteristic curve L2'.

Such an increase in the P-Q characteristic is achieved by increasing the rotational speed of the round-section duct fan. Here, it is assumed that an increase of the P-Q characteristic to that represented by the second P-Q characteristic curve L1' requires an increase in the rotational speed by n times of the rotational speed corresponding to the P-Q characteristic represented by the first P-Q characteristic curve L1.

As mentioned above, when the rotational speed of a fan is increased, the noise produced by the fan becomes louder in proportion to the fifth or sixth power of an increase in the rotational speed. That is, the noise characteristic of the fan is increased in proportion to the fifth or sixth power of an increase in the rotational speed. In addition, as the rotational speed of the fan changes, a shape of the curve representing the noise characteristic of the fan also changes.

The graph G2 of FIG. 11 illustrates the noise characteristic increased in proportion to the fifth or sixth power of the n times increase in the rotational speed of the round-section duct fan, as well as a second noise characteristic curve L3' of which shape is changed depending on the change in the rotational speed.

When the necessary amount of air P1 is provided by the round-section duct fan, noise is increased by an amount corresponding to a difference between the first noise characteristic curve L3 and the second noise characteristic curve L3' on the graph G2 as the rotational speed of the fan increases.

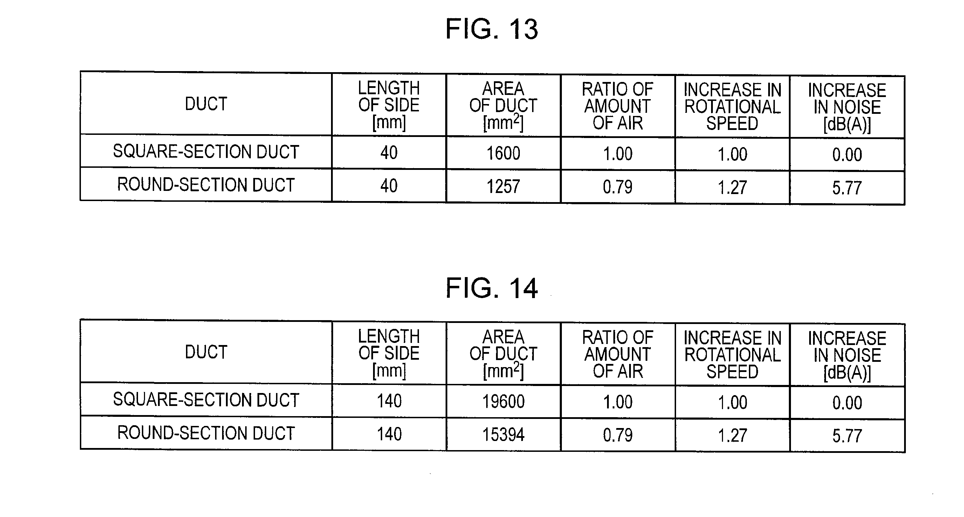

FIG. 13 and FIG. 14 illustrate calculation results of an increase in noise when a round-section duct is attached to a fan as compared with a case when a square-section duct is attached to a fan.

A table of FIG. 13 illustrates calculation results when a square-section duct and a round-section duct as described below are attached respectively to a fan which has a housing formed as a 40-mm square seen from a side in which air flows in which is illustrated in FIG. 5A. The square-section duct is 40 mm in each side and the form thereof is coincident with that of the housing of the fan. The round-section duct is 40 mm in diameter.

A table of FIG. 14 illustrates calculation results when a square-section duct and a round-section duct as described below are attached respectively to a fan which has a housing formed as a 140-mm square seen from a side in which air flows in. The square-section duct is 140 mm in each side. The round-section duct is 140 mm in diameter.

The calculation results in the tables in FIG. 13 and 14 demonstrate that the noise level increased by 5.77 dB(A) in the round-section duct fan as compared with the square-section duct fan. The increase in the noise level is due to an increased rotational speed by 1.27 times in order to increase the amount of air which decreases by 0.79 times with a round-section duct fan as compared with a square-section duct fan.

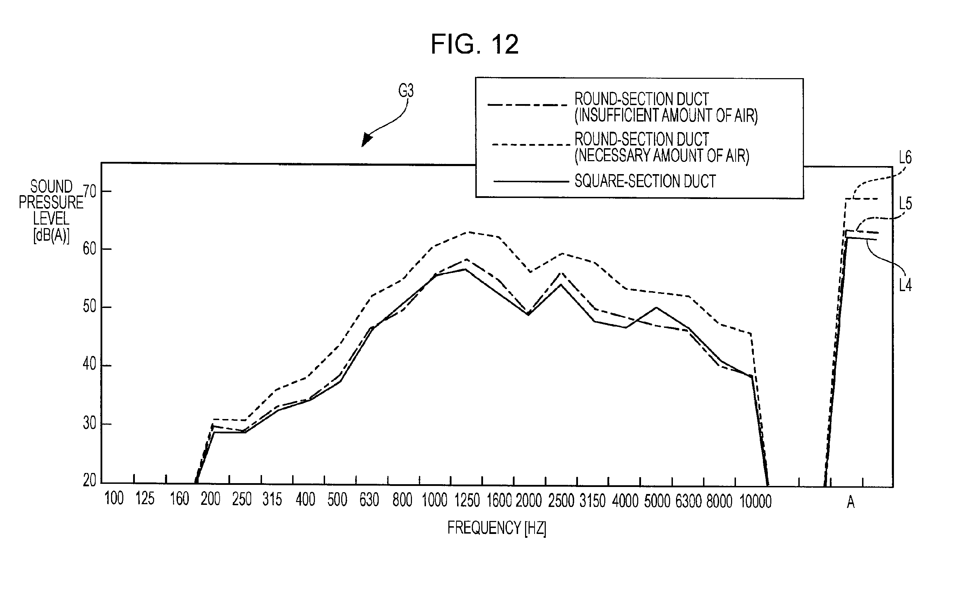

FIG. 12 is a graph representing relationships between noises produced by a square-section duct fan or a round-section duct fan and a rotational frequency of vanes of the fans.

A graph G3 of FIG. 12 illustrates a relationship between noise and a rotational frequency of a fan with a 40 mm-square housing. In the graph G3 of FIG. 12, a rotational frequency of vanes of the fan is plotted in the horizontal axis while a noise level (sound pressure level) is plotted in the vertical axis. The graph G3 includes a first curve L4 which represents, by a solid line, a relationship between the noise and the rotational frequency when a square-section duct is attached to the fan. The graph G3 also includes a second curve L5 which represents, by a dashed dotted line, a relationship between the noise and the rotational frequency when a round-section duct is attached to the fan without changing the ventilation capacity of the fan. The graph G3 also includes a third curve L6 which represents, by a dotted line, a relationship between the noise and the rotational frequency when a round-section duct is attached to the fan with the ventilation capacity of the fan increased until a necessary amount of air is obtained.

The graph G3 of FIG. 12 indicates that the noise produced by the fan with the round-section duct is smaller than that produced by the fan with the square-section duct at the rotational frequency of about 5 kHz when both the fans have the same ventilation capacity. This is because, as described above, the round-section duct has an advantage over the square-section duct in the uniformly of air hitting the vanes. However, when the round-section duct is attached to the fan without changing the ventilation capacity of the fan as described above, ventilation resistance is increased and thus the amount of air which can be supplied is reduced below the necessary amount of air. When the ventilation capacity of the fan is increased until the necessary amount of air is obtained, as indicated by the third curve L6 on the graph G3, the noise level is increased significantly over a wide frequency range.

As described above with reference to FIG. 9 to FIG. 14, the round-section duct has an advantage over the square-section duct in the uniformly of air hitting the vanes but, at the same time, has a defect of higher noise level due to increased ventilation resistance. Therefore, the square-section duct 320 is adopted in the ventilation system 300 of the first embodiment described with reference to FIG. 4 to FIG. 7. Noise produced by the fans 310 is reduced by the square-section duct 320 which guides air so that the air uniformly hits the vanes 312.

In the ventilation system 300, the duct 320 attached to the air inflow end 313a of the housing 313 of the fan 310 functions also as a finger guard during, for example, maintenance of the equipment mounting rack 100 of FIG. 1.

Here, a duct length of the square-section duct 320 is preferably about 1.5 to 4 times the length of each side of a square cross section which corresponds to the dimension of the housing 313 of the fan 310. The duct length will be described below.

The lower limit of the preferred range of the duct length is equivalent to a length with which an amount of noise attenuation by 0.5 dB(A) is obtained. The amount of noise attenuation of 0.5 dB(A) is the minimum amount that can be measured without being considered as a measurement error in an ordinary noise measurement. The upper limit of the preferred range of the duct length is equivalent to a length with which an amount of noise attenuation of 2.0 dB(A) is obtained. The amount of noise attenuation of 2.0 dB(A) is the maximum amount that a human being can perceive noise attenuation.

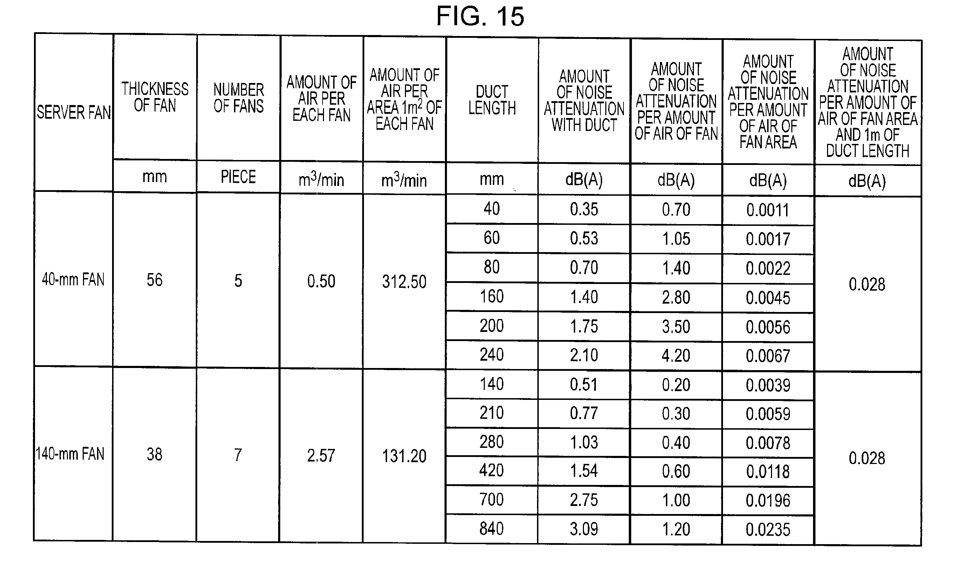

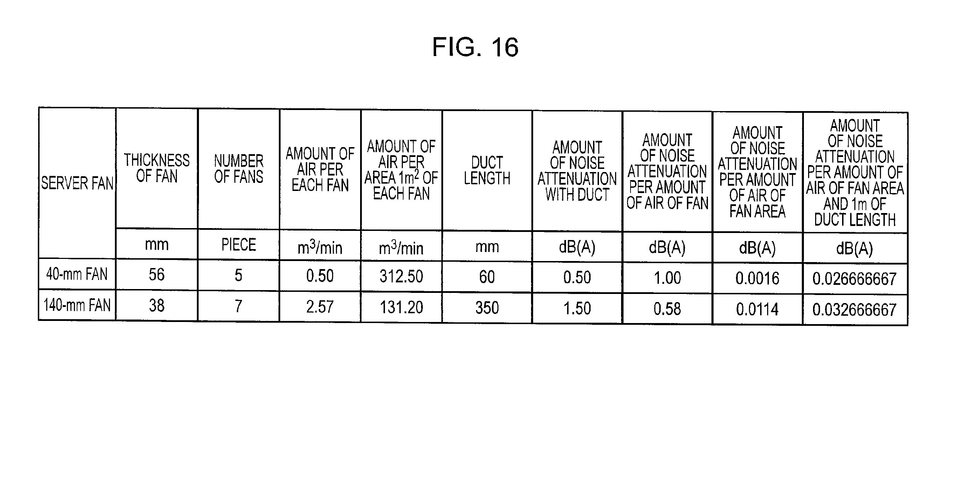

The duct length within these limits can be obtained by calculating the amount of noise attenuation while varying the duct length. The calculation results are illustrated in tables of FIG. 15 and FIG. 16.

The table of FIG. 15 illustrates the amounts of noise attenuation with various duct length for each of the fan having a 40 mm-square housing and the fan having 140 mm-square housing.

The calculation result of the table in FIG. 15 demonstrates that the length with which the amount of noise attenuation of 0.5 dB(A) is obtained is about 1.5 times the length of each side of the square cross section which corresponds to the dimension of the housing of the fan. The calculation result of the table in FIG. 15 also demonstrates that the length with which the amount of noise attenuation of 2.0 dB(A) is obtained is about 4 times the length of each side of the square cross section.

The table of FIG. 16 illustrates the amounts of noise attenuation obtained by the ducts having the length within the above-described preferred range for each of the 40 mm-square duct and the 140 mm-square duct. The table of FIG. 16 indicates that an amount of attenuation of 0.50 dB(A) is obtained with a duct which is 40 mm in each side and 60 mm in length. The table of FIG. 16 indicates that an amount of attenuation of 1.50 dB(A) is obtained with a duct which is 140 mm in each side and 350 mm in length.

The length within the preferred range described above is adopted as the length of the square-section duct 320 in the ventilation system 300 of the first embodiment described with reference to FIG. 4 to FIG. 7.

Note that the housing 313 surrounding the vanes 312 slightly vibrate during the rotation of the vanes 312 of each of the fans 310 although the vibration is suppressed by the duct 320 making the air uniformly hit the vanes 312. The vibration is transmitted to the duct 320 attached to the housing 313. As illustrated in FIG. 4 or FIG. 7, since the adjacent ducts 320 are in contact with one another, the vibration transmitted from the fans 310 to the ducts 320 affect one another.

In the first embodiment, the five ducts 320 each have different characteristic frequencies. Thus, a production of loud noise due to resonance between the ducts 320 can be avoided.

Note that the different characteristic frequencies may be imparted to the ducts 320 by, for example, constituting the ducts 320 by different materials or varying the wall thickness of the ducts 320. However, the method is not particularly limited herein.

In the first embodiment, the five fans 310 have mutually different rotational speed. Thus, the frequencies of vibration produced in the fans 310 are different from each other among the fans 310. Thus, the vibration of the ducts 320 produced by and transmitted from each of the fans 310 as described above is also different from each other among the ducts 320. In the first embodiment, also with this configuration, a production of loud noise due to resonance between the ducts 320 can be avoided.

The five fans 310 of the present embodiment are an example of the plurality of fans in this application.

In a second embodiment, the duct 320 is attached to each of the fans 310 with a following structure.

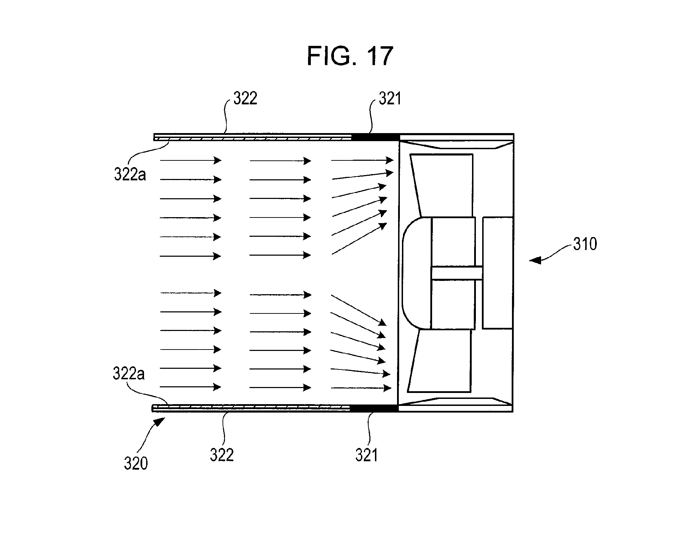

FIG. 17 is a sectional view illustrating a structure in which a duct is attached to each fan according to the second embodiment.

As illustrated in FIG. 17, the duct 320 includes a joint section 321 and an extended portion 322. The joint section 321 is connected to the air inflow end 313a of the housing 313 of the fan 310. The extended portion 322 is connected to and extends from the joint section 321. In the second embodiment, since the joint section 321 is formed of rubber and the extended portion 322 is formed as a metal wall, vibration transmissibility in the joint section 321 is lower than that in the extended portion 322. Thus, transmission of vibration produced in each of the fans 310 to the duct 320 as described above is prevented.

Although the joint section 321 formed of rubber and the extended portion 322 formed of metal are illustrated in the second embodiment, the joint section and the extended portion in this application are not limited to these. The joint section and the extended portion in this application may be formed using materials other than those described above as long as the conditions regarding the vibration transmissibility are satisfied.

In the second embodiment, as illustrated in FIG. 17, the above-described extended portion 322 of the duct 320 is formed as a structure in which a noise-absorbing member 322a formed of rubber is attached to an inner surface of a metal wall. The noise-absorbing member 322a has noise absorbability greater than that of the housing 313 of the fan 310. In the second embodiment, slight noise remaining after being reduced as described above with the thus-structured duct 320 is absorbed by the duct 320.

In the description above, the number of fans and ducts is five as the embodiments of the ventilation system. However, the ventilation system is not limited to the same: any plural number, other than five, of the fans and ducts may be employed.

In the description above, the server devices are mounted in equipment mounting rack. However, the equipment mounting rack is not limited to the same: any rack in which electronic equipment other than the server devices which requires to be cooled may be employed. The numbers of pieces of the mounted electronic equipment is not limited to six as in the embodiment described above.

In the description above, the ventilation system mentioned above is not limited to the same: the ventilation system may be mounted on electronic equipment, such as a server device for the purpose of cooling inside thereof.

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the scope of the invention.

## Claims

1. A ventilation system comprising:
a plurality of fan units, each of the fan units including:
a fan to generate an air stream, and
a duct disposed upstream of the air stream with respect to the fan and defining a flow channel having a square-shaped section to guide air into the fan, the flow channel being coaxial with a rotating shaft of the fan,
wherein the fan units are arranged in a direction crossing the shaft so that the rotating shafts are disposed in parallel to each other.

2. The ventilation system according to claim 1, wherein a length of the flow channel along the shaft is 1.5 to 4 times as long as a length of each side of the square-shaped section of the flow channel.

3. The ventilation system according to claim 1 or 2, wherein the duct has a characteristic frequency different from a characteristic frequency of an adjacent duct.

4. The ventilation system according to claim 1, 2, or 3, wherein the duct includes:
a first portion jointed to the fan, and
a second portion extending from the first portion to a side opposite to the fan,
wherein the first portion has a vibration transmissibility smaller than a vibration transmissibility of the second portion.

5. The ventilation system according to any preceding claim, wherein the fan has a rotational speed different from a rotational speed of an adjacent fan.

6. The ventilation system according to any preceding claim, wherein the duct has a noise absorbability larger than a noise absorbability of a housing member of the fan.

7. A rack apparatus comprising:
a rack which houses an electric device; and
a ventilation system which is disposed in the rack and includes a plurality of fan units, each of the fan units including:
a fan to generate an air stream, and
a duct disposed upstream of the air stream with respect to the fan and defining a flow channel having a square-shaped section to guide air into the fan, the flow channel being coaxial with a rotating shaft of the fan,
wherein the fan units is arranged in a direction crossing the shaft so that the rotating shafts are disposed in parallel to each other.

8. The rack apparatus according to claim 7, further comprising:
a noise absorption member provided on an inner wall of the rack and having a noise absorbability larger than a noise absorbability of the rack.

9. The rack apparatus according to claim 7 or 8, wherein a length of the flow channel along the shaft is 1.5 to 4 times as long as a length of each side of the square-shaped section of the flow channel.

10. The rack apparatus according to claim 8, wherein the duct is in contact with the noise absorption member.
